(19) Europäisches Patentamt / European Patent Office / Office européen des brevets

(11) **EP 3 445 736 B1**

(12) **EUROPÄISCHE PATENTSCHRIFT**

(45) Veröffentlichungstag und Bekanntmachung des Hinweises auf die Patenterteilung:
**06.10.2021 Patentblatt 2021/40**

(51) Int Cl.:
*C04B 35/491* (2006.01)     *C04B 35/493* (2006.01)
*C04B 35/64* (2006.01)     *H01L 41/187* (2006.01)

(21) Anmeldenummer: **17717641.9**

(22) Anmeldetag: **04.04.2017**

(86) Internationale Anmeldenummer:
**PCT/EP2017/057973**

(87) Internationale Veröffentlichungsnummer:
**WO 2017/182263 (26.10.2017 Gazette 2017/43)**

(54) **PIEZOKERAMIK, VERFAHREN ZU DESSEN HERSTELLUNG UND ELEKTROKERAMISCHES BAUELEMENT UMFASSEND DIE PIEZOKERAMIK**

PIEZOELECTRIC CERAMIC, METHOD FOR THE PRODUCTION THEREOF AND ELECTROCERAMIC COMPONENT COMPRISING THE PIEZOCERAMIC

PIÉZO-CÉRAMIQUE, PROCÉDÉ POUR LA PRODUIRE ET COMPOSANT ÉLECTRO-CÉRAMIQUE COMPRENANT LA PIÉZO-CÉRAMIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.04.2016 DE 102016107405**

(43) Veröffentlichungstag der Anmeldung:
**27.02.2019 Patentblatt 2019/09**

(73) Patentinhaber: **TDK Electronics AG**
**81671 München (DE)**

(72) Erfinder:
• OROSEL, Denis
  8530 Deutschlandsberg (AT)
• PUFF, Markus
  8010 Graz (AT)
• DÖLLGAST, Bernhard
  8530 Deutschlandsberg (AT)
• SCHOSSMANN, Michael
  8530 Deutschlandsberg (AT)

(74) Vertreter: **Epping - Hermann - Fischer**
**Patentanwaltsgesellschaft mbH**
**Schloßschmidstraße 5**
**80639 München (DE)**

(56) Entgegenhaltungen:
EP-A1- 1 702 905     WO-A2-03/101946
WO-A2-2004/032255     JP-A- 2010 258 199
US-A1- 2006 229 187     US-A1- 2014 285 070

• Hyeung: "Dielectric and Piezoelctric Properties of Pb(Zr1/2Ti1/2)-Pb(Cu1/3Nb2/3)O3-Pb(Mn1/3Nb2/3)O3 System", , 1. Oktober 2005 (2005-10-01), XP55384500, Gefunden im Internet: URL:http://ocean.kisti.re.kr/downfile/volume/kcs/SRMHB8/2005/v42n10s281/SRMHB8_2005_ v42n10s281_698.pdf [gefunden am 2017-06-23]

**Beschreibung**

Die vorliegende Erfindung betrifft eine harte Blei-Zirkonat-Titanat (PZT) Keramik wie sie beispielsweise in piezoelektrischen Bauelementen, insbesondere Transformatoren, eingesetzt wird. Die Erfindung betrifft weiterhin ein Verfahren zur Herstellung der harten PZT-Keramik sowie einen keramischen Werkstoff, welcher durch das Verfahren erhältlich ist. Ferner betrifft die Erfindung ein elektrokeramisches Bauelement, welches die Keramik beziehungsweise den keramischen Werkstoff enthält.

Ferroelektrische harte PZT-Materialien können hohen elektrischen und mechanischen Belastungen standhalten. Vor allem Resonanzanwendungen, beispielsweise in Form eines piezoelektrischen Transformators, profitieren von den Eigenschaften harter Piezomaterialien. Aus der WO 2004/032255 A2 ist ein piezoelektrischer Transformator mit Kupferinnenelektroden und einer harten Piezokeramik bekannt. Solche herkömmlichen Materialsysteme können jedoch dazu führen, dass sich das piezoelektrische Bauteil während des Sinterprozesses verzieht. Es ist daher eine Aufgabe der vorliegenden Erfindung eine Keramikrezeptur anzugeben, welche eine formgenauere Herstellung eines elektrokeramischen Bauelements wie beispielsweise eines piezoelektrischen Transformators ermöglicht.

Hyeung G. L.: "Dielectric and Piezoelectric Properties of Pb $(Zr_{1/2}Ti_{1/2})$-Pb$(Cu_{1/3}Nb_{2/3})O_3$-Pb$(Mn_{1/3}Nb_{2/3})O_3$ System" untersucht die dielektrischen und piezoelektrischen Eigenschaften von komplexem Perowskit 0.92Pb $(Zr_{1/2}Ti_{1/2})O_3$(0.08-x)Pb$(Cu_{1/3}Nb_{2/3})O_{3-x}$Pb$(Mn_{1/3}Nb_{2/3})O_3$(0≤x≤0. 080) (PZT-PCN-PMN) Systemen als Funktion des PMN-Gehalts.

US 2006/0229187 A1 betrifft eine Klasse von keramischen Zusammensetzungen gemäß der Formel $Pb_{(1-z)}M_z(Mn_{1/3}Sb_{2/3})_x(Zr_yTi_{1-y})_{1-x}O_3$, wobei M entweder Sr oder Ba, x zwischen 0,01 und 0,1, y zwischen 0,35 und 0,55 und z zwischen 0,01 und 0,10 ausgewählt ist. In einigen Ausführungsformen der obigen Komposition werden den Zusammensetzungen ein oder mehrere Dotiermittel zugesetzt. Das/die Dotiermittel kann/können aus der Gruppe ausgewählt werden, die umfasst: $PbO$, $CeO_2$, $SnO_2$, $Sm_2O_3$, $TeO_2$, $MoO_3$, $Nb_2O_5$, $SiO_2$, $CuO$, $CdO$, $HfO_2$, $Pr_2O_3$ und Mischungen davon. Die Dotiermittel können der keramischen Zusammensetzung in Einzelmengen von 0,01 Gew.-% bis zu 5,0 Gew.-% zugesetzt werden.

JP 2010-258199 A zielt darauf ab ein piezoelektrisches Element und ein Verfahren zur Herstellung desselben bereitzustellen, bei dem ein organisches Bindemittel auch bei niedrigem Sauerstoffpartialdruck leicht entfernt werden kann. Die für die Entfernung benötigte Zeit wird verkürzt, während die Oxidation von Cu in einer Elektrodenschicht unterdrückt und die piezoelektrischen Eigenschaften beibehalten werden. Dies wird durch Bereitstellung eines piezoelektrischen Elements bestehend aus einer piezoelektrischen Schicht, die aus einer piezoelektrischen Zusammensetzung besteht, die Bleizirkonattitanat als Hauptkomponente, Mn und/oder Co als erste Unterkomponente, Cu als zweite Unterkomponente, Nb und/oder Ta als dritte Unterkomponente und mindestens eine aus Ce, Nd und La als vierte Unterkomponente ausgewählte Art enthält; und einer Elektrodenschicht, die hauptsächlich aus Cu besteht, erreicht. Zudem kann das piezoelektrische Element gebildet werden, das Sr und/oder Ca als fünfte Unterkomponente der piezoelektrischen Keramikschicht anstelle der vierten Unterkomponente enthält.

WO 2004/032255 A2 betrifft einen piezoelektrischen Transformator mit mindestens zwei Keramikelementen aus einer Pb$(Zr_xTi_{1-x})O_3$+yPb$(Mn_{1/3}Nb_{2/3})O_3$ enthaltenden Zusammensetzung und einer zwischen den zwei Keramikelementen angeordneten Elektrode, bei dem die Elektrode Kupfer enthält.

WO 03/101946 A2 offenbart eine piezokeramische Zusammensetzung mit der allgemeinen Summenformel $Pb_{1-a}RE_bZr_xTi_yTR_zO_3$, bei der RE mindestens ein aus der Gruppe Europium, Gadolinium, Lanthan, Neodym, Praseodym, Promethium und/oder Samarium ausgewähltes Seltenerdmetall mit einem Seltenerdmetallanteil b ist, TR mindestens ein aus der Gruppe Chrom, Eisen und/oder Mangan ausgewähltes Übergangsmetall mit einer Übergangsmetallwertigkeit WTR und einem Übergangsmetallanteil z ist und folgender Zusammenhang gültig ist: z > b/(4 - WTR). Durch ein nicht-stöchiometrisches Dotierungsverhältnis aus Übergangsmetall- und Seltenerdmetall-Dotierung werden homogene PZT-Kristalle mit maximaler Korngrösse auch bei niedriger Sintertemperatur erreicht. Durch Variation der Dotierungen können die piezoelektrischen Eigenschaften einer PZT-Keramik mit der Zusammensetzung von denen eines klassischen Weich-PZTs bis hin zu denen eines klassischen Hart-PZTs geändert werden. Der piezokeramische Körper ist beispielsweise ein Piezoaktor in monolithischer Vielschichtbauweise, der aufgrund eines grossen d33-Koeffizienten und eines niedrigen inneren Verlust im Grosssignalbereich für Mehrfacheinspritzungen im Motor eines Kraftfahrzeugs einsetzbar ist.

US 2014/0285070 A1 offenbart ein Keramikmaterial, umfassend Bleizirkonat-Titanat, das zusätzlich Nd, K und gegebenenfalls Cu enthält. Vorzugsweise weist das Keramikmaterial die allgemeine Zusammensetzung $ABO_3$ eines Perowskit-Gitters aufweist, wobei A für die A-Plätze und B für die B-Plätze des Perowskit-Gitters stehen und Nd, K und gegebenenfalls Cu A-Plätze im Perowskit-Gitter einnehmen.

EP 1702905 A1 offenbart eine piezoelektrische Keramikzusammensetzung, umfassend als Hauptbestandteil ein Kompositoxid, das Pb, Ti und Zr als Bestandteile enthält. Es enthält als ersten Hilfsstoff mindestens ein Element, ausgewählt aus der Gruppe bestehend aus Mn, Co, Cr, Fe und Ni, in einer Menge von 0,2 Masse-% oder weniger, ausgenommen 0 Masse-% in Form eines Oxids. Alternativ kann als erster Hilfsstoff mindestens eine Spezies ausgewählt aus den durch $CuO_x$ dargestellten Bestandteilen, wobei x ≥ 0, verwendet werden. In diesem Fall beträgt der Gehalt des ersten Zubehörbestandteils 3,0 Masse-% oder weniger, ausgenommen 0 Masse-%. Die piezoelektrische Keramikzusammensetzung wird unter reduzierenden Brennbedingungen gesintert.

Diese Aufgabe wird erfindungsgemäß durch die Gegenstände der unabhängigen Ansprüche gelöst. Vorteilhafte Ausgestaltungen sind Gegenstand der abhängigen Ansprüche.

Die erfindungsgemäße harte Blei-Zirkonat-Titanat (PZT) Keramik der allgemeinen Struktur $ABO_3$ kennzeichnet, dass sie auf den B-Plätzen eine Dotierung mit Mn und zusätzlich auf den A-Plätzen und/oder auf den B-Plätzen eine Dotierung mit Cu aufweist, wobei die A-Plätze mindestens eine weitere Dotierung mit Na und/oder K aufweisen.

Eine harte PZT-Keramik wird durch Dotieren der Grundzusammensetzung mit einem Dotierelement geringerer Wertigkeit (Akzeptor) im Vergleich zu den entsprechenden Gitteratomen auf den A- und B-Plätzen erhalten. Harte PZT-Keramiken können durch niedrige mechanische Verluste ($Q_m$ = 1000 bis 2000) beziehungsweise dielektrische Verluste ($\tan\delta$ = 0,3 bis 0,4%) gekennzeichnet sein.

Die vorliegende Erfindung beruht auf der Erkenntnis, dass bei der gemeinsamen Sinterung von mehrschichtigen piezoelektrischen Keramikbauteilen mit inneren Kupferelektroden im Allgemeinen Kupfer aus den Elektroden in die Keramik diffundiert. Dieses Kupfer wird zu einem Bestandteil der Keramikzusammensetzung und beeinflusst deren Eigenschaften wie zum Beispiel Dichte, Korngröße und Gefügeausbildung. Aufgrund der Diffusionsgeschwindigkeit des Kupfers ist dieser Einfluss im Nahbereich der Kupferelektroden stärker ausgeprägt als in Keramikbereichen, welche weiter von den Elektroden entfernt liegen. Dies kann zu Problemen führen, wenn Bereiche der Keramik wie zum Beispiel Isozonen oder Hochspannungsteile so weit von Kupferelektroden entfernt sind, dass die Kupferdiffusion in diese Bereiche nur unvollständig oder gar nicht erfolgt. Aufgrund unterschiedlicher Kupfergehalte in den elektrodennahen und elektrodenfernen Bereichen kommt es dann während des Sintervorgangs zu Unterschieden in der Schwindung der Keramik. Diese führt zu einem mechanischen Verzug der Bauelemente. Gleichzeitig beeinträchtigt der unterschiedliche Kupfergehalt die gleichmäßige Auslenkung der Keramik im Betrieb.

Die erfindungsgemäße Keramikrezeptur ist dagegen so angegeben, dass die wesentlichen Gitterplätze schon in der Grünkeramik mit Kupfer vorbesetzt sind. Auf diese Weise bleibt der Kupferaustausch zwischen den Elektroden und der Keramik beim Sintern im Wesentlichen ohne Auswirkungen auf die Schwindung und/oder die Auslenkung im Arbeitsbetrieb. Dadurch erreichen die Erfinder eine verbesserte Einhaltung der Geometrie und ein verbessertes Auslenkungsverhalten von piezoelektrischen Bauelementen mit Kupferinnenelektroden. Gleichzeitig bleiben die vorteilhaften Materialeigenschaften einer harten PZT-Keramik erhalten.

Erfindungsgemäß weist die PZT-Keramik auf den A-Plätzen mindestens eine weitere Dotierung mit Na und/oder K auf.

Vorzugsweise umfassen die B-Plätze eine Dotierung mit Cu. Auf den B-Plätzen kann auch eine Dotierung mit Fe, Nb, Zn, Ge, Sn, Al, Ga oder Sb sowie beliebigen Kombinationen dieser Dotierelemente vorliegen. Neben Cu umfassen die B-Plätze vorzugsweise auch eine Dotierung mit Nb.

Die Dotierung auf den A-Plätzen und/oder B-Plätzen der Keramik umfasst vorzugsweise bis zu 1,0 Atom% Cu, insbesondere 0,05 bis 0,1 Atom% Cu. Die Erfinder haben festgestellt, dass diese Kupfermengen in der PZT-Keramik den Effekt der Kupferdiffusion besonders vorteilhaft ausgleicht, so dass das Schwindungs- beziehungsweise Auslenkungsverhalten der Keramik in Bereichen mit und ohne Kupferinnenelektroden im Wesentlichen gleich ist.

Es ist auch möglich, dass lediglich die B-Plätze und nicht die A-Plätze der Keramik Cu umfassen.

Die Dotierung auf den B-Plätzen kann bis zu bis zu 5,0 Atom% Mn umfassen. Bevorzugt sind 2,0 bis 3,0 Atom% Mn. Auf diese Weise werden besonders niedrige dielektrische Verluste bei gleichzeitig hoher elektromechanischer Kopplungseffizienz erreicht.

Gemäß einer bevorzugten Ausgestaltung weist die PZT-Keramik eine allgemeine Formel

$$(Pb1-(a\cdot2/m)Mma\cdot2/m)1-y(Zr1-x-(b\cdot4/n)TixNnb\cdot4/n)yO3$$

auf. Hierin steht Mm für eine oder mehrere Dotierungen M der jeweiligen Wertigkeit m, Nn für eine oder mehrere Dotierungen N der jeweiligen Wertigkeit n. Weiterhin gilt: $0 \leq a \leq 0,1$; $0 < b \leq 0,2$; $0,2 \leq x \leq 0,8$ und $0,4 \leq y \leq 0,6$.

Durch die angegebene Berücksichtigung der Wertigkeit der Inhaltsstoffe und die entsprechende Anpassung des Pb-Gehaltes beziehungsweise Zr/Ti-Gehaltes der Zusammensetzung wird erfindungsgemäß gewährleistet, dass die Elektroneutralität Keramik gewahrt wird.

Das Verhältnis von (1-x-(b·4/n) zu x liegt vorzugsweise im Bereich von 0,9 bis 1,1. Für y gilt vorzugsweise $0,4 \leq y \leq 0,6$. Für (a·2/n) gilt bevorzugt $0,0001 \leq (a\cdot2/m) \leq 0,05$. Für (b·4/n) gilt vorzugsweise $0,0001 \leq (b\cdot4/n) \leq 0,1$.

Die vorliegende Erfindung betrifft weiterhin ein Verfahren zur Herstellung eines keramischen Werkstoffs, welcher die vorgehend beschriebene harte Blei-Zirkonat-Titanat (PZT)-Keramik umfasst. Das Verfahren umfasst die Schritte:

A) Bereitstellen von Ausgangsstoffen Pb, Zr und Ti und Dotierelementen umfassend Mn und Cu sowie Na und/oder K,

B) Mischen und Mahlen der Ausgangsstoffe und Dotierelemente zur Herstellung einer Ausgangsmischung,

C) Sintern der Ausgangsmischung zur harten PZT-Keramik um den keramischen Werkstoff zu erhalten, wobei mindestens Cu in der Ausgangsmischung in einem überstöchiometrischen Anteil in Bezug auf den Anteil des Dotierelements in der harten PZT-Keramik vorliegt und in Schritt C) zumindest ein Teil des Dotierelements Cu in einer reduzierenden Atmosphäre zum Metall reduziert wird.

Erfindungsgemäß wird mindestens das Dotierelement Cu in der Ausgangsmischung in einem überstöchiometrischen Anteil in Bezug auf den Anteil des Dotierelements in der harten PZT-Keramik vorgelegt. Unter dieser Voraussetzung konnten die Erfinder eine überraschende Selbstregulierung der Elektroneutralität der PZT-Keramik während des Herstellungsverfahrens feststellen.

Erfindungsgemäß wird Schritt C) in einer Sinteratmosphäre durchgeführt, in welcher mindestens eines der Dotierelemente seine Valenz ändern kann. Dadurch wird erfindungsgemäß erreicht, dass sich die gewünschte elektroneutrale Keramikzusammensetzung in Abhängigkeit vom Prozess einstellt und weniger stark von der Herstellung der Ausgangsmischung abhängt.

Erfindungsgemäß wird in Schritt C) zumindest ein Teil mindestens des Dotierelements Cu zum Metall reduziert, das heißt bis zur Oxidationsstufe Null. Der zum Metall reduzierte Teil des Dotierelements Cu kann sich in der Form kleiner Metallpartikel im keramischen Werkstoff abscheiden.

Da diese Metallabscheidungen nicht mehr für die Keramikzusammensetzung zur Verfügung stehen, stellt sich nach überraschender Erkenntnis der Erfinder eine Art gepuffertes System zwischen dem in der Keramik eingebauten Dotierelement und dem zum Metall reduzierten Dotierelement ein, wodurch der Anteil des Dotierelements in der Keramik selbstregulierend wird. Dieser überraschende Effekt wirkt sich beispielsweise vorteilhaft auf den Herstellungsprozess aus, indem eine elektroneutrale Keramikzusammensetzung unabhängiger von der Einwaage des Dotierelements in der Ausgangsmischung abhängt beziehungsweise weniger vom Ausmaß der Kupferdiffusion aus Elektroden in die Keramikzusammensetzung beeinflusst wird.

Ein keramischer Werkstoff, der durch dieses Verfahren erhältlich ist umfasst demnach die harte PZT-Keramik und in der PZT-Keramik verteilte metallische Abscheidungen, zum Beispiel in Partikelform. Dabei können die metallischen Abscheidungen beziehungsweise Partikel mindestens eines der Dotierelemente in elementarer Form, insbesondere elementares Kupfer oder elementares Silber, umfassen.

Folglich wird eine keramische Zusammensetzung mit einer keramischen Komponente und einer metallischen Komponente bereitgestellt, wobei die keramische Komponente eine harte Blei-Zirkonat-Titanat (PZT)-Keramik wie oben beschrieben umfasst. Die metallische Komponente umfasst demnach ein Dotierelement, welches auch in der harten Blei-Zirkonat-Titanat (PZT)-Keramik enthalten ist, in einer zum Metall reduzierten Form. Diese Form kann amorph und/oder im Wesentlichen partikulär sein.

Insbesondere ist in den vorgenannten Verfahrensvarianten vorgesehen, dass das in dem überstöchiometrischen Anteil vorgelegte Dotierelement in der Sinteratmosphäre seine Valenz ändern beziehungsweise zum Metall reduziert werden kann. Beispielsweise kann Cu oder, falls vorhanden, Ag in einem überstöchiometrischen Anteil vorliegen. Ein Valenzwechsel von Cu(II) beziehungsweise Cu(I) zu Cu(0) wird erfindungsgemäß in einer reduzierenden Sinteratmosphäre bewirkt. Für einen Valenzwechsel von Ag(I) zu Ag(0) kann das Sintern in einer oxidierenden Atmosphäre, beispielsweise Luft, durchgeführt werden. Vorzugsweise wird der Sintervorgang in Schritt C) in Bezug auf den Sauerstoffpartialdruck und die Temperatur an der Gleichgewichtslinie zwischen dem oxidierten und dem metallischen Zustand des Dotierelements geführt. Geeignete Bedingungen sind dem Fachmann bekannt oder können ohne weiteres vorhergesagt werden (Ellingham, H. J. T. (1944), "Transactions and Communications", J. Soc. Chem. Ind. (London) 63, 125).

Vorzugsweise wird die Ausgangsmischung in Schritt C) bei unter 1000 °C zur harten PZT-Keramik gesintert. Bevorzugte Sintertemperaturen liegen im Bereich von 920 °C bis 980 °C. Auf diese Weise können harte PZT-Keramiken mit hoher Dichte hergestellt werden, welche sich durch geringe dielektrische Verluste und hohe elektromechanische Kopplungseffizienzen auszeichnen.

In einem weiteren Aspekt betrifft die Erfindung ein elektrokeramisches Bauelement, insbesondere einen Transformator, in monolithischer Vielschichtbauweise. Das Bauelement umfasst einen Stapel aus übereinanderliegenden Keramikschichten und wenigstens zwei dazwischenliegenden Elektrodenschichten, wobei die Elektrodenschichten elementares Kupfer enthalten und wobei die Keramikschichten eine harte PZT-Keramik beziehungsweise einen keramischen Werkstoff gemäß der vorgehenden Beschreibung umfassen. Die erfindungsgemäßen Bauelemente zeichnen sich durch eine hohe Formgenauigkeit und gleichmäßiges Auslenkungsverhalten aus.

Das elektrokeramische Bauelement kann so ausgestaltet sein, dass eine Keramikschicht des Stapels an Elektrodenschichten angrenzende Teilbereiche und weiter entfernte Teilbereiche, welche mehr als 1,5 mm, insbesondere mehr als 2 mm oder mehr als 4 mm, von den an die Keramikschicht angrenzenden Elektrodenschichten beabstandet sind, aufweist. Solche weiter entfernte Teilbereiche liegen in der Regel außerhalb der Diffusionszone des Kupfers, welches während des Sintervorgangs aus den Elektrodenschichten austritt. Daher stellen sich bei herkömmlichen Keramiken oftmals derart unterschiedliche Kupfergehalte in den an die Elektrodenschichten angrenzenden Teilbereichen und weiter entfernten Teilbereichen ein, dass es zu einem unterschiedlichen Schwindungsverhalten in den Teilbereichen und dadurch zum Verzug der geometrischen Form des Bauelements kommt. Gleichzeitig beeinträchtigen die unterschiedlichen Kupfergehalte in den Teilbereichen das Auslenkungsverhalten des Bauelements. Demgegenüber hat die erfindungsgemäße Keramik den Vorteil, dass die Effekte der Kupferdiffusion überlagert beziehungsweise kompensiert werden und somit der Verzug am fertigen Bauteil minimiert oder sogar vollständig vermieden werden kann. Dadurch erhöht sich die Qualitätsklasse des elektrokeramischen Bauelements.

Es ist zum Beispiel möglich, dass sich die an die Elektrodenschichten angrenzenden Teilbereiche und die weiter entfernten Teilbereiche in ihrem Kupfergehalt um nicht mehr als 10 Atom% unterscheiden.

Die Vorteile der erfindungsgemäßen PZT-Keramik kommen insbesondere bei piezoelektrischen Bauelementen größerer Baugröße zum Tragen, welche für einen Verzug der geometrischen Form durch Vorgänge der Schwindung besonders anfällig sind. Es ist zum Beispiel möglich, dass die Keramikschichten des erfindungsgemäßen Bauelements eine Hauptoberfläche umfassen, welche eine Länge von mindestens 50 mm oder von mindestens 70 mm aufweist. In bestimmten Ausgestaltungen kann die Länge der Hauptoberfläche bis zu 150 mm oder bis zu 100 mm betragen. Die Breite der Hauptoberfläche kann mindestens 4 mm oder mindestens 6 mm betragen. Vorzugsweise beträgt die Breite der Hauptoberfläche bis zu 25 mm oder bis zu 18 mm. Weiterhin ist es möglich, dass höchstens 75%, insbesondere höchstens 60% oder höchstens 50% der Hauptoberfläche einer oder mehrerer Keramikschichten mit einer Elektrodenschicht bedeckt sind. Solche Bauformen können mit Hilfe der erfindungsgemäßen PZT-Keramik besonders formgenau bereitgestellt werden.

Im Folgenden wird die Erfindung anhand von Figuren und Ausführungsbeispielen näher beschrieben, was jedoch nicht als Beschränkung des Erfindungsgegenstandes aufzufassen ist.

Die Erfindung wird in den Ansprüchen definiert.

Figur 1 zeigt schematisch eine Aufsicht auf eine Hauptoberfläche einer Keramikschicht KS mit einer auf der Keramikschicht angeordneten Kupferinnenelektrode EL. An die Elektrodenschicht angrenzende Teilbereiche AT und weiter entfernte Teilbereiche ET sind durch unterschiedliche Schraffuren gekennzeichnet.

Figur 2 zeigt Aufnahmen von einer Seitenfläche (a) und einer Hauptoberfläche (b) eines elektrokeramischen Bauelements in monolithischer Vielschichtbauweise mit Cu-Innenelektroden und Keramikschichten, die mit einer erfindungsgemäßen harten PZT-Keramik gefertigt wurden.

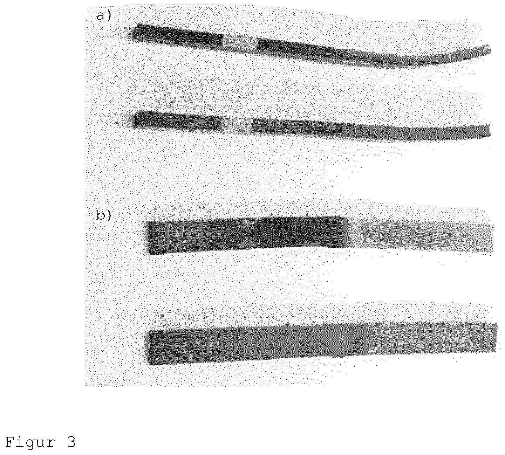

Figur 3 zeigt Aufnahmen von Seitenflächen (a) und Hauptoberflächen (b) von elektrokeramischen Bauelemente in monolithischer Vielschichtbauweise mit Cu-Innenelektroden und Keramikschichten, die mit einer herkömmlichen harten PZT-Keramik ohne Cu-Dotierung gefertigt wurden.

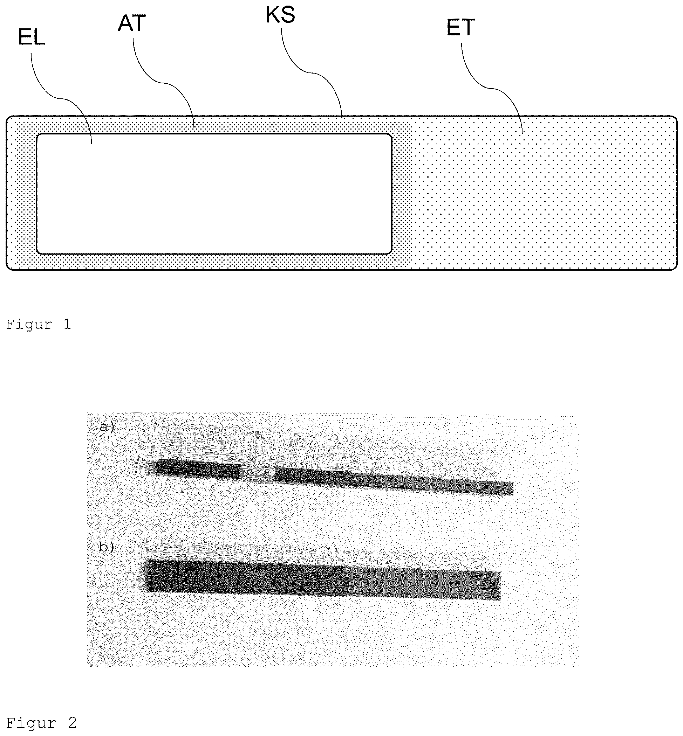

In einem erfindungsgemäßen Ausführungsbeispiel wurde die PZT-Keramik mit Dotierungen von 0,0075 Atom% Na auf den A-Plätzen und 0,054 Atom% Nb, 0,027 Atom% Mn und 0,003 Atom% Cu auf den B-Plätzen erprobt. Als Vergleichsbeispiel wurde die entsprechende PZT-Keramik lediglich ohne die Cu-Dotierung verwendet. Die PZT-Keramiken wurden mit Kupferinnenelektroden in monolithischer Vielschichtbauweise zu elektrokeramischen Bauelementen verarbeitet. Die Keramikschichten hatten eine Hauptoberfläche mit einer Länge von etwa 71 mm und einer Breite von etwa 6 mm. Die Stapelhöhe der Bauteile betrug etwa 2,8 mm. Die mithilfe der erfindungsgemäßen PZT-Keramik gefertigten elektrokeramischen Bauelemente wiesen besonders vorteilhafte Eigenschaften in Bezug auf Formgenauigkeit und Auslenkungsverhalten auf (Figur 2). Dagegen waren Bauelemente, welche mit der herkömmlichen Keramik gefertigt wurden, von einem erheblichen Verzug sowohl in Stapelrichtung des Bauteils (Figur 2a) als auch quer zur Stapelrichtung (Figur 2b) gekennzeichnet.

Bezugszeichen

KS     Keramikschicht
EL     Kupferinnenelektrode
AT     an Elektrodenschicht angrenzende Teilbereiche
ET     von Elektrodenschicht weiter entfernte Teilbereiche

**Patentansprüche**

1. Eine harte Blei-Zirkonat-Titanat (PZT)-Keramik der allgemeinen Struktur $ABO_3$, **dadurch gekennzeichnet, dass** die PZT-Keramik auf den B-Plätzen eine Dotierung mit Mn und zusätzlich auf den A-Plätzen und/oder auf den B-Plätzen eine Dotierung mit Cu aufweist, wobei die A-Plätze mindestens eine weitere Dotierung mit Na und/oder K aufweisen.

2. Die PZT-Keramik nach einem der vorhergehenden Ansprüche, wobei die B-Plätze mindestens eine weitere Dotierung mit Fe, Nb, Zn, Ge, Sn, Al, Ga oder Sb, vorzugsweise Nb, aufweisen.

3. Die PZT-Keramik nach einem der vorhergehenden Ansprüche, wobei die Dotierung auf den A-Plätzen und/oder B-Plätzen bis zu 1,0 Atom% Cu, vorzugsweise 0,05 bis 0,1 Atom% Cu, umfasst.

4. Die PZT-Keramik nach einem der vorhergehenden Ansprüche, wobei die Dotierung auf den B-Plätzen bis zu 5,0 Atom% Mn, vorzugsweise 2,0 bis 3,0 Atom% Mn, umfasst.

5. Die PZT-Keramik nach einem der vorhergehenden Ansprüche, wobei die Keramik eine allgemeine Formel

$$(Pb_{1-(a \cdot 2/m)}Mm_{a \cdot 2/m})_{1-y}(Zr_{1-x-(b \cdot 4/n)}Ti_xNn_{b \cdot 4/n})_yO_3$$

aufweist, wobei Mm für eine oder mehrere Dotierungen der jeweiligen Wertigkeit m steht, Nn für eine oder mehrere Dotierungen der jeweiligen Wertigkeit n steht, und wobei gilt: $0 \le a \le 0,1$; $0 < b \le 0,2$; $0,2 \le x \le 0,8$ und $0,4 \le y \le 0,6$.

6. Ein Verfahren zur Herstellung eines keramischen Werkstoffs mit harter Blei-Zirkonat-Titanat (PZT)-Keramik nach einem der vorhergehenden Ansprüche, mit den Schritten

   A) Bereitstellen von Ausgangsstoffen Pb, Zr und Ti und Dotierelementen umfassend Mn und Cu sowie Na und/oder K,
   B) Mischen und Mahlen der Ausgangsstoffe und Dotierelemente zur Herstellung einer Ausgangsmischung,
   C) Sintern der Ausgangsmischung zur harten PZT-Keramik um den keramischen Werkstoff zu erhalten, wobei mindestens Cu in der Ausgangsmischung in einem überstöchiometrischen Anteil in Bezug auf den Anteil des Dotierelements in der harten PZT-Keramik vorliegt und in Schritt C) zumindest ein Teil des Dotierelements Cu in einer reduzierenden Sinteratmosphäre zum Metall reduziert wird.

7. Ein keramischer Werkstoff erhältlich durch das Verfahren nach Anspruch 6, wobei der keramische Werkstoff die harte PZT-Keramik und in der PZT-Keramik verteilte metallische Abscheidungen, zum Beispiel metallische Partikel, umfasst.

8. Ein elektrokeramisches Bauelement, insbesondere ein Transformator, in monolithischer Vielschichtbauweise mit einem Stapel aus übereinanderliegenden Keramikschichten und wenigstens zwei dazwischenliegenden Elektrodenschichten, wobei die Elektrodenschichten elementares Kupfer enthalten und wobei die Keramikschichten eine harte PZT-Keramik nach einem der Ansprüche 1 bis 5 beziehungsweise einen keramischen Werkstoff nach Anspruch 7 umfassen.

9. Das elektrokeramische Bauelement nach dem vorhergehenden Anspruch, wobei eine Keramikschicht des Stapels an Elektrodenschichten angrenzende Teilbereiche und weiter entfernte Teilbereiche, welche mehr als 1,5 mm, insbesondere mehr als 2 mm oder mehr als 4 mm, von den an die Keramikschicht angrenzenden Elektrodenschichten beabstandet sind, aufweist.

10. Das elektrokeramische Bauelement nach dem vorhergehenden Anspruch, wobei sich die an die Elektrodenschichten angrenzende Teilbereiche und die weiter entfernten Teilbereiche in ihrem Cu-Gehalt um nicht mehr als 10% unterscheiden.

11. Das elektrokeramische Bauelement nach einem der Ansprüche 8 bis 10, wobei die Keramikschichten eine Hauptoberfläche umfassen, welche eine Länge von 50 bis 150 mm, vorzugsweise von 70 bis 100 mm, und/oder eine Breite von 4 bis 25 mm, vorzugsweise von 6 bis 18 mm aufweist.

12. Das elektokeramische Bauelement nach dem vorhergehenden Anspruch, wobei höchstens 75%, insbesondere höchstens 60% oder höchstens 50%, der Hauptoberfläche einer Keramikschicht mit einer Elektrodenschicht bedeckt sind.

**EP 3 445 736 B1**

**Claims**

1. Hard lead zirconate titanate (PZT) ceramic of the general structure $ABO_3$, **characterized in that** the PZT ceramic has doping with Mn on the B sites and additionally doping with Cu on the A sites and/or on the B sites, wherein the A sites have at least one further doping with Na and/or K.

2. PZT ceramic according to any of the preceding claims, wherein the B sites have at least one further doping with Fe, Nb, Zn, Ge, Sn, Al, Ga or Sb, preferably Nb.

3. PZT ceramic according to any of the preceding claims, wherein the doping on the A sites and/or B sites comprises up to 1.0 atom% of Cu, preferably from 0.05 to 0.1 atom% of Cu.

4. PZT ceramic according to any of the preceding claims, wherein the doping on the B sites comprises up to 5.0 atom% of Mn, preferably from 2.0 to 3.0 atom% of Mn.

5. PZT ceramic according to any of the preceding claims, wherein the ceramic has a general formula (Pb1-(a·2/m)Mma·2/m)1-y(Zr1-x-(b·4/n) TixNnb·4/n)yO3, where Mm represents one or more dopings having the respective valence m, Nn represents one or more dopings having the respective valence n and: $0 \leq a \leq 0.1$; $0 < b \leq 0.2$; $0.2 \leq x \leq 0.8$ and $0.4 \leq y \leq 0.6$.

6. Process for producing a ceramic material comprising a hard lead zirconate titanate (PZT) ceramic according to any of the preceding claims, comprising the steps:

   A) Provision of starting materials Pb, Zr and Ti and doping elements comprising Mn and Cu and also Na and/or K,
   B) Mixing and milling of the starting materials and doping elements to produce a starting mixture,
   C) Sintering of the starting mixture to the hard PZT ceramic in order to obtain the ceramic material, wherein at least Cu is present in a superstoichiometric proportion relative to the proportion of the doping element in the hard PZT ceramic in the starting mixture and in step C) at least a portion of the doping element Cu is reduced to the metal in a reducing sintering atmosphere.

7. Ceramic material obtainable by the process according to Claim 6, wherein the ceramic material comprises the hard PZT ceramic and metallic precipitates, for example metallic particles, dispersed in the PZT ceramic.

8. Electroceramic component, in particular a transducer, having a monolithic multilayer structure and comprising a stack of superposed ceramic layers and at least two electrode layers located in between, wherein the electrode layers contain elemental copper and the ceramic layers comprise a hard PZT ceramic according to any of Claims 1 to 5 or a ceramic material according to Claim 7.

9. Electroceramic component according to the preceding claim, wherein a ceramic layer of the stack has subregions adjoining the electrode layers and subregions which are further away and are at a distance of more than 1.5 mm, in particular more than 2 mm or more than 4 mm, away from the electrode layers adjoining the ceramic layer.

10. Electroceramic component according to the preceding claim, wherein the subregions adjoining the electrode layers and the subregions which are further away have Cu contents which differ by not more than 10%.

11. Electroceramic component according to any of Claims 8 to 10, wherein the ceramic layers have a main surface which has a length of from 50 to 150 mm, preferably from 70 to 100 mm, and/or a width of from 4 to 25 mm, preferably from 6 to 18 mm.

12. Electroceramic component according to the preceding claim, wherein not more than 75%, in particular not more than 60% or not more than 50%, of the main surface of a ceramic layer is covered with an electrode layer.

**Revendications**

1. Céramique dure au zirconate-titanate de plomb (PZT) de structure générale $ABO_3$, **caractérisée en ce que**

7

la céramique au PZT présente un dopage au Mn aux positions B et en outre un dopage au Cu aux positions A et/ou aux positions B et

**en ce que** les positions A présentent en outre un autre dopage au Na et/ou au K.

2.  Céramique au PZT selon la revendication précédente, dans laquelle les positions B présentent au moins un autre dopage au Fe, Nb, Zn, Ge, Sn, Al, Ga ou Sb et de préférence au Nb.

3.  Céramique au PZT selon l'une des revendications précédentes, dans laquelle le dopage aux positions A et/ou aux positions B comporte jusque 1,0 % atomique de Cu et de préférence de 0,05 à 0,1 % atomique de Cu.

4.  Céramique au PZT selon l'une des revendications précédentes, dans laquelle le dopage aux positions B comporte jusque 5,0 % atomiques de Mn et de préférence de 2,0 à 3,0 % atomiques de Mn.

5.  Céramique au PZT selon l'une des revendications précédentes, dans laquelle la céramique présente la formule générale $(Pb_{1-(a\cdot2/m)}Mm_{a\cdot2/m})_{1-y}(Zr_{1-x-(b\cdot4/n)}Ti_xNn_{b\cdot4/n})_yO_3$, dans laquelle Mm représente un ou plusieurs dopages de valence m, Nn un ou plusieurs dopages de valence n et $0 < a < 0,1$ ; $0 < b < 0,2$ ; $0,2 < x < 0,8$ et $0,4 < y < 0,6$.

6.  Procédé de fabrication d'un matériau contenant une céramique dure au zirconate-titanate de plomb (PZT) selon l'une des revendications précédentes, le procédé comprenant les étapes qui consistent à :

    A) préparer les matières de départ Pb, Zr et Ti et des éléments de dopage comprenant Mn et Cu ainsi que Na et/ou K,
    B) mélanger et broyer les matières de départ et les éléments de dopage pour ainsi obtenir un mélange de départ,
    C) fritter le mélange de départ de céramique au PZT pour obtenir le matériau céramique, au moins Cu étant présent dans le mélange de départ en quantité sur-stoechiométrique par rapport à la teneur en l'élément de dopage dans la céramique au PZT, au moins une partie de l'élément de dopage Cu étant réduite en le métal dans une atmosphère réductrice à l'étape C).

7.  Matériau céramique obtenu en recourant au procédé selon la revendication 6, le matériau céramique comprenant la céramique dure au PZT et des dépôts métalliques, par exemple des particules métalliques, dispersés dans la céramique au PZT.

8.  Composant électrocéramique, en particulier transformateur à structure monolithique multicouche présentant un empilement de couches céramiques superposées entre lesquelles sont disposées au moins deux couches d'électrode, les couches d'électrode comprenant du cuivre élémentaire et les couches céramiques comportant une céramique dure au PZT selon l'une des revendications 1 à 5 ou un matériau céramique selon la revendication 7.

9.  Composant électrocéramique selon la revendication précédente, dont une couche céramique de l'empilement présente des parties adjacentes aux couches d'électrode et d'autres parties qui en sont éloignées et distantes de plus de 1,5 mm, en particulier de plus de 2 mm ou de plus de 4 mm des couches d'électrode adjacentes à la couche céramique.

10. Composant électrocéramique selon la revendication précédente, dans lequel les parties adjacentes aux couches d'électrode et les autres parties qui en sont éloignées se distinguent par des teneurs en Cu qui ne diffèrent pas entre elles de plus de 10 %.

11. Composant électrocéramique selon l'une des revendications 8 à 10, dont les couches céramiques comportent ne surface principale d'une longueur de 50 à 150 mm et de préférence de 70 à 100 mm et/ou une largeur de 4 à 25 mm et de préférence de 6 à 18 mm.

12. Composant électrocéramique selon la revendication précédente dont au plus 75 % et en particulier au plus 60 % ou au plus 50 % de la surface principale sont recouverts d'une couche céramique dotée d'une couche d'électrode.

EL AT KS ET

Figur 1

a)

b)

Figur 2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004032255 A2
- US 20060229187 A1
- JP 2010258199 A
- WO 03101946 A2
- US 20140285070 A1
- EP 1702905 A1

**In der Beschreibung aufgeführte Nicht-Patentliteratur**

- **ELLINGHAM, H. J. T.** Transactions and Communications. *J. Soc. Chem. Ind.,* 1944, vol. 63, 125